(19) **Europäisches Patentamt / European Patent Office / Office européen des brevets**

(11) **EP 3 944 351 B1**

(12) **EUROPEAN PATENT SPECIFICATION**

(45) Date of publication and mention of the grant of the patent:
**29.04.2026 Bulletin 2026/18**

(21) Application number: **19917521.7**

(22) Date of filing: **19.03.2019**

(51) International Patent Classification (IPC):
**H10K 39/12** $^{(2026.01)}$    **H10K 85/50** $^{(2023.01)}$
**H10K 30/40** $^{(2023.01)}$    **H10K 102/10** $^{(2023.01)}$

(52) Cooperative Patent Classification (CPC):
**H10K 85/50; H10K 39/12;** H10K 30/40; H10K 39/10;
H10K 71/12; H10K 77/111; H10K 85/1135;
H10K 2102/103; Y02E 10/542; Y02E 10/549;
Y02P 70/50

(86) International application number:
**PCT/JP2019/011479**

(87) International publication number:
**WO 2020/188751 (24.09.2020 Gazette 2020/39)**

(54) **PHOTOELECTRIC CONVERSION ELEMENT AND METHOD FOR PRODUCING PHOTOELECTRIC CONVERSION ELEMENT**

PHOTOELEKTRISCHES UMWANDLUNGSELEMENT UND VERFAHREN ZUR HERSTELLUNG DES PHOTOELEKTRISCHEN UMWANDLUNGSELEMENTS

ÉLÉMENT DE CONVERSION PHOTOÉLECTRIQUE ET PROCÉDÉ DE PRODUCTION D'ÉLÉMENT DE CONVERSION PHOTOÉLECTRIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(43) Date of publication of application:
**26.01.2022 Bulletin 2022/04**

(73) Proprietors:
• **Kabushiki Kaisha Toshiba**
  **Minato-ku, Tokyo 105-8001 (JP)**
• **Toshiba Energy Systems & Solutions Corporation**
  **Saiwai-ku**
  **Kawasaki-shi**
  **Kanagawa 2120013 (JP)**

(72) Inventors:
• **OOOKA Haruhi**
  **Tokyo**
  **1050023 (JP)**
• **NAKAO Hideyuki**
  **Tokyo**
  **1050023 (JP)**

• **FUJINAGA Kenji**
  **Kawasaki-shi**
  **Kanagawa**
  **2120013 (JP)**

(74) Representative: **Hoffmann Eitle Patent- und Rechtsanwälte PartmbB Arabellastraße 30 81925 München (DE)**

(56) References cited:
**WO-A1-2018/043644    WO-A1-2018/123402**
**JP-A- 2018 056 213    US-A1- 2018 211 791**
**US-A1- 2019 019 843**

• **LI KUNPENG ET AL: "An efficient, flexible perovskite solar module exceeding 8% prepared with an ultrafast Pbl2 deposition rate", SCIENTIFIC REPORTS, vol. 8, no. 1, 11 January 2018 (2018-01-11), XP055957773, DOI: 10.1038/s41598-017-18970-y**

EP 3 944 351 B1

- W. QIU ET AL: "Pinhole-free perovskite films for efficient solar modules", ENERGY & ENVIRONMENTAL SCIENCE, vol. 9, no. 2, 1 January 2016 (2016-01-01), Cambridge, pages 484 - 489, XP055496256, ISSN: 1754-5692, DOI: 10.1039/C5EE03703D
- ZHEN LI ET AL: "Scalable fabrication of perovskite solar cells", NATURE REVIEWS MATERIALS, vol. 3, no. 4, 27 March 2018 (2018-03-27), XP055654979, DOI: 10.1038/natrevmats.2018.17
- T. JESPER JACOBSSON ET AL: "Unreacted Pbl 2 as a Double-Edged Sword for Enhancing the Performance of Perovskite Solar Cells", JOURNAL OF THE AMERICAN CHEMICAL SOCIETY, vol. 138, no. 32, 4 August 2016 (2016-08-04), pages 10331 - 10343, XP055539926, ISSN: 0002-7863, DOI: 10.1021/jacs.6b06320
- ZHENG, ENQIANG ET AL.: "Pbl2-Based Dipping-Controlled Material Conversion for Compact Layer Free Perovskite Solar Cells", ACS APPLIED MATERIALS & INTERFACES, vol. 7, 2015, pages 18156 - 18162, XP055741003
- CHEN, HAINING: "Two-Step Sequential Deposition of Organometal Halide Perovskite for Photovoltaic Application", ADVANCED FUNCTIONAL MATERIALS, vol. 27, 2017, pages 1605654, XP055741007

**Description**

FIELD

Arrangements of the present invention relate to a photoelectric conversion device and a method of manufacturing the photoelectric conversion device.

BACKGROUND

Perovskite compounds are expected to be applied to photoelectric conversion devices such as a photovoltaic, a light emitting element, and a photosensor. Using the perovskite compounds as, for example, forming materials of active layers of photoelectric conversion devices such as a photovoltaic makes it possible to employ an inexpensive coating method for forming the active layers, and thus enables a great reduction in a formation cost of the active layers. Because of this, a perovskite photovoltaics as a next-generation photovoltaics that cost low and are harmless.

Cells forming a photovoltaic module each have a structure in which an active layer is sandwiched by a substrate electrode and a counter electrode. As the substrate electrode, a conductive oxide not having sufficient conductivity is typically used, and accordingly, as the area of the cell increases, efficiency for extracting generated electric charges to the outside deteriorates more. To solve this, a plurality of strip-shaped cells are formed side by side and the plural cells are connected in series. A series photovoltaic module having the plural cells is formed by the following method, for instance. The substrate electrodes of the respective cells are formed on a transparent substrate. An active layer is formed on the whole surface of the plural substrate electrodes by coating. Parts of the active layer are scribed, whereby grooves from which the substrate electrodes are exposed are formed. Counter electrodes are formed on the active layer having the scribe grooves so as to correspond to the respective cells. At this time, in the scribe groove, the counter electrode of the adjacent cell is filled, so that the counter electrode of the adjacent cell is electrically connected with the substrate electrode exposed to the inside of the scribe groove.

The scribing of the active layer is executed by mechanical scribing using a cutting tool or laser scribing using laser light, for instance. The hard conductive metal oxide layer exists under the soft, viscous, and low-brittleness active layer such as a perovskite compound layer, and thus at the time of scribing the active layer, the active layer is likely to remain in the scribe grooves and on the conductive metal oxide. The active layer, if remaining, increases electrical resistance between the counter electrode of the adjacent cell and the substrate electrode, resulting in deterioration of power conversion efficiency. Increasing a scribing pressure or output power of laser in order to prevent the active layer from remaining is likely to cause, e.g., a crack in the conductive metal oxide layer. In a case where the substrate as the base of the conductive metal oxide layer is a soft substrate such as a resin substrate, the increase in the pressure especially at the time of the mechanical scribing causes the soft substrate to deform by being pushed by a cutting tool, which is more likely to cause a crack in the conductive metal oxide layer.

In order to prevent the crack of the conductive metal oxide layer while reducing the remaining of the active layer at the time of the scribing, studies are being made on forming a conductive layer under part of the active layer that is to be scribed and scribing the active layer together with a thickness-direction part of the conductive layer. Since the thickness-direction part of the conductive layer which is easy to scribe is scribed together with the active layer, it is possible to reduce the remaining of the active layer. Further, since the easiness of scribe of the active layer is enhanced, it is possible to reduce, for example, a load of an excessive pressure to the conductive metal oxide layer. However, if part of the conductive layer is, for example, mechanically scribed, cutting chips of the conductive layer produced at the time of the scribing may become the residue in the periphery. Such cutting chips of a conductive substance cause, e.g., a short circuit between the cells. The above circumstances have given rise to a demand for an art to improve electrical connectivity between the adjacent cells (photoelectric conversion elements) by achieving both the reduction of the remaining of the active layer on the substrate electrodes and the prevention of breakage of the substrate electrodes and by inhibiting, e.g., a short circuit between the cells due to the cutting chips of the conductive substance, at the time of the scribing of the active layer.

In addition, the scribing of the active layer without the conductive layer under the active layer to be scribed can save a manufacturing cost of the conductive layer and a raw material cost thereof.

Furthermore, Kunpeng Li et al. reports in "An efficient, flexible perovskite solar module exceeding 8% prepared with an ultrafast PbI2 deposition rate", Scientific Reports, vol. 8, no. 1, 11 January 2018, p. 1-7 on the fabrication of large-area, pinhole-free $CH_3NH_3PbI_3$ perovskite thin films on 5 cm x 5 cm flexible indium tin oxide coated polyethylene naphthalate (ITO-PEN) substrates through a sequential evaporation/spin-coating deposition method.

Enqiang Zheng et al. reports in "PbI2-Based Dipping- Controlled Material Conversion for Compact Layer Free Perovskite Solar Cells", ACS Applied Materials & Interfaces, vol. 7, 2015, pages 18156-18162 on a two-step sequential deposition method to prepare a CH3NH3PbI3 active layer from a PbI2 precursor in perovskite solar cells (PSCs). A solvent vapor annealing (SVA) method to prepare PbI2 crystallites with large grain size for preparation of high quality perovskite is reported. A reduction of the photovoltaic performance of resulting PSCs, without a significant change in PbI2/ CH3NH3PbI3 contents in the perovskite films, when the PbI2 dipping time in CH3NH3I solution increases is reported.

RELEVANT REFERENCES

Patent Reference

Reference1: JPB 5715795
Reference 2: JPB 6030176

SUMMARY

A problem to be solved by the present invention is to perform, when manufacturing a photoelectric conversion element using a perovskite compound, patterning of a film with high efficiency in an inexpensive manner.

A photoelectric conversion element of an embodiment, includes: a substrate; a first photoelectric conversion element including a first substrate electrode arranged on the substrate, a first active layer arranged on the first substrate electrode, and a first counter electrode arranged on the first active layer; a second photoelectric conversion element including a second substrate electrode arranged on the substrate and physically separated from the first substrate electrode, a second active layer arranged on the second substrate **electrode,** and a second counter electrode arranged on the second active layer; and a connection including a groove and a conductive portion, the groove penetrating through the second active layer from a surface of the second active layer to expose a surface of the second substrate electrode from the second active layer, the conductive portion including a part of the first counter electrode filled in the groove, and the connection electrically connecting the first counter electrode and the second substrate electrode via the conductive portion. The second active layer is represented by a composition formula: $A_\alpha BX_\chi$, where A denotes at least one cation selected from the group consisting of monovalent cations, B denotes at least one cation selected from the group consisting of bivalent cations, and X denotes at least one ion selected from the group consisting of monovalent halogen ions; and the second active layer has a first and a second compound layer, the first compound layer containing a first compound satisfying $0.95 \leq \alpha$, and $2.95 \leq \chi$, the second compound layer being arranged between the first compound layer and the second substrate electrode, and the second compound layer containing a second compound satisfying $0.2 < \alpha < 0.4$, and $2.2 < \chi < 2.4$.

BRIEF DESCRIPTION OF THE DRAWINGS

FIG. 1 is a cross-sectional schematic view illustrating a structural example of a photoelectric conversion device.
FIGS. 2A to 2C are cross-sectional schematic views each illustrating a structural example of a photoelectric conversion layer and a connection.
FIG. 3 is a cross-sectional schematic view illustrating another structural example of the photoelectric conversion device.
FIG. 4 is a view illustrating a configuration example of a coating apparatus applying a meniscus coating method.
FIG. 5 is a TEM image of a cross section including an active layer.
FIG. 6 is a view obtained when a portion indicated by a broken line in FIG. 5 is enlarged and turned counterclockwise by 90 degrees.
FIG. 7 is a view illustrating a line element analysis result.
FIGS. 8A to 8D are views for explaining a method example of manufacturing a photovoltaic module.
FIGS. 9A to 9C are views for explaining the method example of manufacturing the photovoltaic module.
FIGS. 10A to 10C are sectional views for explaining a method example of manufacturing a photoelectric conversion device.
FIGS. 11A and 11B are plan views each explaining a method example of manufacturing a photoelectric conversion device.
FIGS. 12A to 12C are views for explaining a connecting step of photoelectric conversion elements and a configuration of the connection.
FIGS. 13A to 13C are cross-sectional schematic views each illustrating a structural example of a dividing groove.
FIG. 14 is a view illustrating a state in which an active layer is subjected to mechanical scribing with the use of a scribing blade.
FIG. 15 is an observation image of a cross section of a photoelectric conversion device module of an example 1.

FIG. 16 is an observation image of a cross section of a photoelectric conversion device module of an example 1.

DETAILED DESCRIPTION

Hereinafter, a photoelectric conversion device of an arrangement and a manufacturing method thereof will be described with reference to the drawings. in respective arrangements, substantially the same constituent portions are denoted by the same reference numerals, and explanation thereof is sometimes partially omitted. The drawings are schematic, and the relation of thickness and planer dimension, a thickness ratio of the respective parts, and so on are sometimes different from actual ones. The term indicating a direction such as an upper or lower direction in the explanation, indicates a relative direction when a forming surface of a photoelectric conversion element of a substrate to be described later is faced upward, unless otherwise specified, and is sometimes different from an actual direction based on a gravitational acceleration direction.

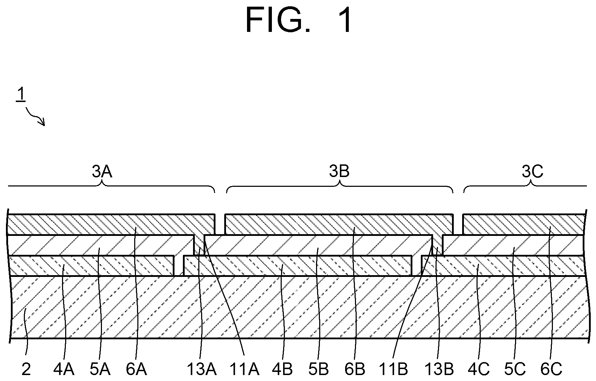

FIG. 1 is a cross-sectional schematic view illustrating a structural example of a photoelectric conversion device of an arrangement. A photoelectric conversion device 1 illustrated in FIG. 1 includes a substrate 2 that functions as a supporting substrate, and a plurality of photoelectric conversion elements 3 (3A, 3B, 3C) arranged on the substrate 2. The photoelectric conversion elements 3 each include a substrate electrode 4 (4A, 4B, 4C), a photoelectric conversion layer 5 (5A, 5B, 5C), and a counter electrode 6 (6A, 6B, 6C) which are formed on the substrate 2 in the above-described order. The photoelectric conversion device 1 further includes connections 13 (13A, 13B) each including a dividing groove 11 (11A, 11B) from which a surface of the substrate electrode 4 is exposed, and a conductive portion formed of a part of the counter electrode 6 filled in the dividing groove 11, and the connection electrically connecting two photoelectric conversion elements 3 via the conductive portion.

An example of the present embodiment includes that: the substrate 2 includes a substrate transparent to light; the substrate electrode 4 includes a substrate electrode transparent to light and formed on the substrate 2; and the transparent substrate and the transparent substrate electrode enables to receive and emit light through the substrate 2. However, another example of the embodiment can include another configurations different from the above configurations. The other example of the embodiment includes: the photoelectric conversion layer 5 is formed on an opaque substrate as the substrate 2; and the substrate electrode 4 includes a transparent substrate electrode formed on the photoelectric conversion layer 5.

The substrate 2 is formed of a material having a light-transmitting property and insulation performance. As the constituent material of the substrate 2, an inorganic material such as non-alkali glass, quartz glass, or sapphire, or an organic material such as polyethylene (PE), polyethylene terephthalate (PET), polyethylene naphthalate (PEN), polyimide, polyamide, polyamide-imide, or a liquid crystal polymer is used. For example, the transparent substrate 2 may be a rigid substrate formed of an inorganic material or an organic material, or may be a flexible substrate formed of an organic material or a very thin inorganic material.

In a case where the photoelectric conversion device 1 of the embodiment is a photovoltaic, the photoelectric conversion layer 5 is irradiated with light through the substrate 2 and the substrate electrode 4. In a case where the photoelectric conversion device 1 is a light emitting element, light generated in the photoelectric conversion layer 5 is emitted through the substrate 2 and the substrate electrode 4. To take the case where the photoelectric conversion device 1 is a photovoltaic, charge separation is caused by the light irradiating the photoelectric conversion layer 5, so that electrons and holes are generated. Out of the electrons and the holes generated in the photoelectric conversion layer 5, for example, the electrons are collected in the substrate electrode 4, and the holes are collected in the counter electrode 6. The functions of the substrate electrode 4 and the counter electrode 6 may be reversed. Hereinafter, these parts will be described.

The substrate electrode 4 is formed of a material having a light-transmitting property and conductivity. As the constituent material of the substrate electrode 4, a conductive metal oxide such as indium oxide, zinc oxide, tin oxide, indium tin oxide (ITO), fluorine-doped tin oxide (FTO), gallium-doped zinc oxide (GZO), aluminum-doped zinc oxide (AZO), indium-zinc oxide (IZO), or indium-gallium-zinc oxide (IGZO) is used. The substrate electrode 4 may be a film stack of a layer formed of any of the aforesaid materials and a metal layer formed of metal such as gold, platinum, silver, copper, cobalt, nickel, indium, or aluminum, or an alloy containing any of these metals, within a range capable of maintaining the light-transmitting property. The substrate electrode 4 is formed by, for example, a vacuum deposition method, a sputtering method, an ion plating method, a CVD method, a sol-gel method, a plating method, or a coating method.

The thickness of the substrate electrode 4 is not particularly limited, but is preferably not less than 10 nm nor more than 1 $\mu$m, and more preferably not less than 30 nm nor more than 300 nm. When the substrate electrode 4 is too thin, sheet resistance becomes high. When the film thickness of the substrate electrode 4 is too thick, light transmittance decreases, and further flexibility decreases, so that, e.g, a crack is likely to occur due to a stress. It is preferable to select the film thickness of the substrate electrode 4 so that high light transmittance and low sheet resistance are both obtained. The sheet resistance of the substrate electrode 4 is not particularly limited, but is typically 1000 $\Omega/\square$ or less, preferably 500$\Omega/\square$ or less, and more preferably 200 $\Omega/\square$ or less.

Each layer of the photoelectric conversion layer 5 is determined in accordance with the type of a module which to the device 1 is applied, the module being selected from a photovoltaics, a light emitting element, or a photosensor.

The counter electrode 6 is formed of a material having conductivity, and in some case, having a light-transmitting property. As the constituent material of the counter electrode 6, metal such as platinum, gold, silver, copper, nickel, cobalt, iron, manganese, tungsten, titanium, zirconium, tin, zinc, aluminum, indium, chromium, lithium, sodium, potassium, rubidium, cesium, calcium, magnesium, barium, samarium, or terbium, an alloy containing any of these, a conductive metal oxide such as an indium-zinc oxide (IZO), or a carbon material such as graphene or carbon nanotube is used, for example.

The counter electrode 6 is formed by, for example, a vacuum deposition method, a sputtering method, an ion plating method, a sol-gel method, a plating method, or a coating method. The thickness of the counter electrode 6 is not particularly limited, but preferably is not less than 1 nm nor more than 1 $\mu$m. When the film thickness of the counter electrode 6 is too thin, resistance becomes too high, which may make it impossible to sufficiently transmit the generated electric charges to an external circuit. When the thickness of the counter electrode 6 is too thick, its film formation takes a long time and accordingly a material temperature increases, which may damage the active layer 51. Sheet resistance of the counter electrode 6 is not particularly limited, but is preferably 500 $\Omega/\square$ or less, and more preferably 200 $\Omega/\square$ or less.

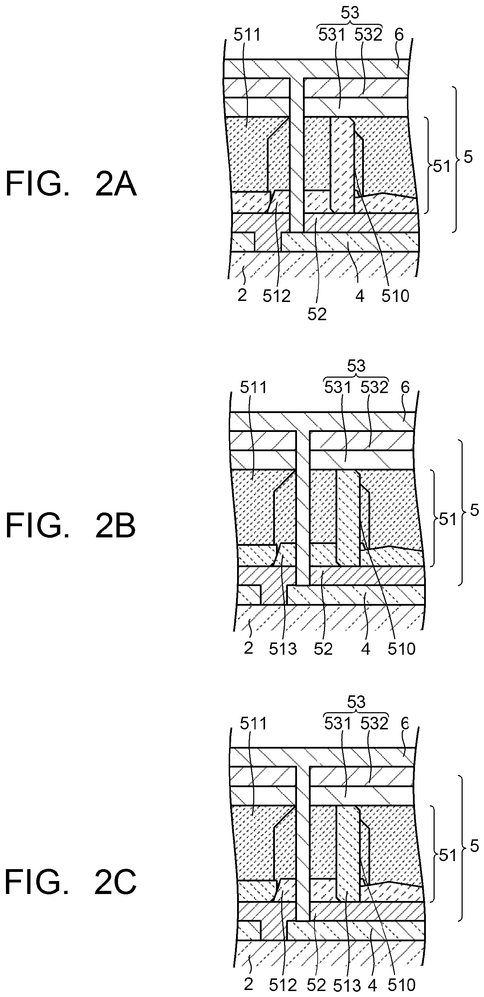

FIG. 2A to FIG. 2C are cross-sectional schematic views each illustrating a structural example of the photoelectric conversion layer 5 and the connection 13. The photoelectric conversion layer 5 has an active layer 51, an intermediate layer 52 arranged between the substrate electrode 4 and the active layer 51, and an intermediate layer 53 arranged between the active layer 51 and the counter electrode 6. The intermediate layer 53 has an intermediate layer 531 and an intermediate layer 532.

A thickness of the active layer 51 is not limited, but is preferably 10 nm or more and 1000 nm or less. The intermediate layer 52 and the intermediate layer 53 can be arranged as needed, and both or one of them can be omitted in some case.

In the case where the electrons generated in the photoelectric conversion layer 5 are collected in the substrate electrode 4, the intermediate layer 52 is formed of a material capable of selectively and efficiently transporting the electrons. As the constituent material of the intermediate layer 52 functioning as an electron transport layer, an inorganic material such as zinc oxide, titanium oxide, or gallium oxide, an organic material such as polyethyleneimine or its derivative, or a carbon material such as the aforesaid fullerene derivative is used, and the constituent material is not particularly limited.

In the case where the holes are collected in the substrate electrode 4, the intermediate layer 52 is formed of a material capable of selectively and efficiently transporting the holes. As the constituent material of the intermediate layer 52 functioning as a hole transport layer, an inorganic material such as nickel oxide, copper oxide, vanadium oxide, tantalum oxide, or molybdenum oxide, or an organic material such as polythiophene, polypyrrole, polyacetylene, triphenylenediaminepolypyrrol, polyaniline, or a derivative of any of these is used, and the constituent material is not particularly limited.

In the case where the holes generated in the photoelectric conversion layer 5 are collected in the counter electrode 6, the intermediate layer 53, that is, the intermediate layer 531 and the intermediate layer 532 are formed of a material capable of selectively and efficiently transporting the holes. The constituent material of the intermediate layer 53 functioning as the hole transport layer is the same as the constituent material of the intermediate layer 52. In the case where the electrons are collected in the counter electrode 6, the intermediate layer 531 and the intermediate layer 532 are formed of a material capable of selectively and efficiently transporting the electrons. The constituent material of the intermediate layer 53 functioning as the electron transport layer is the same as the constituent material of the intermediate layer 52.

The intermediate layers 531, 532 are formed by, for example, a vacuum deposition method, a sputtering method, an ion plating method, a CVD method, a sol-gel method, a plating method, or a coating method. The intermediate layers 531, 532 each preferably have a thickness of not less than 1 nm nor more than 20 nm.

The active layer 51 is represented by a composition formula: $A_{\alpha}BX_{\chi}$. In the composition formula: $A_{\alpha}BX_{\chi}$, A denotes at least one cation selected from the group consisting of monovalent cations, B denotes at least one cation selected from the group consisting of bivalent cations, and X denotes at least one ion selected from the group consisting of monovalent halogen ions. Examples of A include an organic amine compound such as $CH_3NH_4$, cesium (Cs), and rubidium (Rb). Examples of B include lead (Pb) and tin (Sn). Examples of X include halogens such as iodine (I), bromine (B), and chlorine (Cl). The material of each of A, B, and X sites can include not only one material but also a plurality of materials. A material example of X include the combination of iodine and bromine. Further, the combination of the elements is to set the total thereof to satisfy the composition formula: $A_{\alpha}BX_{\chi}$. If the material of X include a combination of iodine and bromine, the active layer 51 is represented by a composition formula: $ABI_IBr_{II}$. When $\chi$ is set to 3, the formula is to satisfy $I + II = 3$. An example of the composition formula is described below so that the composition formula is set to $ABX_3$, in which each of A, B, and X sites includes a combination of the materials.

Composition formula: $(CH_3NH_3)_{0.5}Cs_{0.5}Pb_{0.5}Sn_{0.5}I_{1.5}Br_{1.5}$

As illustrated in FIG. 2A to FIG. 2C, the active layer 51 can have any of three stacked structures. The active layer 51 illustrated in FIG. 2A includes a perovskite compound layer 511 and an unreacted compound layer 512, the perovskite compound layer 511 being arranged closer to the counter electrode 6 than the unreacted compound layer 512 is, and the unreacted compound layer 512 being arranged closer to the substrate electrode 4 than the perovskite compound layer 511 is and arranged between the perovskite compound layer 511 and the substrate electrode 4. The active layer 51 illustrated in FIG. 2B includes a perovskite compound layer 511 and a partially reacted compound layer 513, the perovskite compound layer 511 being arranged closer to the counter electrode 6 than partially reacted compound layer 513 is, and the partially reacted compound layer 513 being arranged closer to the substrate electrode 4 than the perovskite compound layer 511 is and arranged between the perovskite compound layer 511 and the substrate electrode 4. The active layer 51 illustrated in FIG. 2C includes a perovskite compound layer 511, an unreacted compound layer 512, and a partially reacted compound layer 513, the perovskite compound layer 511 being arranged closer to the counter electrode 6 than the unreacted compound layer 512 is, and the layers 512 and 513 being arranged closer to the substrate electrode 4 than the perovskite compound layer 511 and being arranged between the perovskite compound layer 511 and the substrate electrode 4.

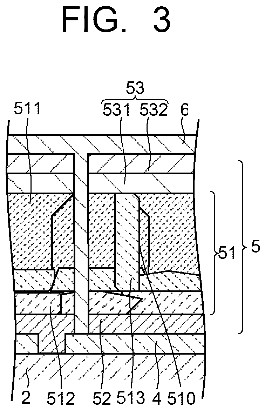

At least a part of the unreacted compound layer 512 or at least a part of the partially reacted compound layer 513 is provided between the perovskite compound layer 511 and the substrate electrode 4. The active layer 51 can also have a crystal grain boundary 510 between crystals of compounds. A conductive portion including a part of the counter electrode 6 can penetrate the unreacted compound layer 512 or the partially reacted compound layer 513 to be electrically connected to the substrate electrode 4. The structure of the active layer 51 is not limited to the structures illustrated in FIG. 2A to FIG. 2C, and the active layer 51 can also have a stacked structure including the perovskite compound layer 511, the unreacted compound layer 512, and the partially reacted compound layer 513, as illustrated in FIG. 3.

The perovskite compound layer 511 contains a perovskite compound. Examples of the perovskite compound include a compound represented by a composition formula: $ABX_3$. This compound can have a composition represented by a composition formula: $A_\alpha BX_\chi$ and satisfying $0.95 \leq \alpha$, and $2.95 \leq \chi$.

The perovskite compound preferably include a three-dimensional perovskite crystal. It is empirical knowledge that a three-dimensional perovskite crystal is obtained and high power conversion efficiency is obtained in a case where a tolerance factor t expressed by the following expression is within a range of not less than 0.75 nor more than 1.1. In the following expression, a Shannon ionic radius is used, though there are several kinds of ionic radii.

$$t = (A\text{ site ionic radius} + X\text{ site ionic radius})/\{2^{1/2} \times (B\text{ site ionic radius} + X\text{ site ionic radius})\}$$

The unreacted compound layer 512 contains an unreacted compound. Examples of the unreacted compounds include a compound having a composition represented by the composition formula: $A_\alpha BX_\chi$ and satisfying $\alpha \fallingdotseq 0$ and $\chi \fallingdotseq 2$. This composition corresponds to a composition represented by a composition formula: $BX_2$.

The partially reacted compound layer 513 contains a partially reacted compound. In the claimed invention, the partially reacted compound includes a compound having a composition represented by the composition formula: $A_\alpha BX_\chi$ and satisfying $0.2 < \alpha < 0.4$ and $2.2 < \chi < 2.4$.

Method examples of forming the active layer 51 include evaporating a perovskite compound or its precursor in a vacuum, applying a solution containing a perovskite compound or its precursor dissolved in a solvent and then heating and drying it. Examples of the precursor include a mixture of methylammonium halide and lead halide or a mixture of methylammonium halide and tin halide.

As the active layer 51, a stacked structure including the layer 511 and at least one selected from the group consisting of the layers 512 and 513 is preferably formed by a so-called two-step method. The two-step method includes a first step of forming a $BX_2$ compound layer and a second step of supplying an AX compound onto the $BX_2$ compound layer to react with each other and thus form an $ABX_3$ layer (perovskite compound layer). The method examples of forming the active layer 51 also include vacuum evaporation, or applying a solution and then heating and drying.

The use of such methods can adjust a supply amount of the AX compound, and a reaction time and a reaction rate between the $BX_2$ compound layer and the AX compound to simply form the stacked structure. For example, when a less AX compound is subjected to vacuum evaporation on the $BX_2$ compound layer, a part thereof is reacted to form the perovskite compound layer 511, and the remainder thereof forms the unreacted compound layer 512 or the partially reacted compound layer 513. An another method example includes dissolving the AX compound into a solution ant then contact the AX compound onto the $BX_2$ compound layer for a short period of time, to reduce a reaction time, resulting in reacting a part thereof to form the perovskite compound layer 511, and the remainder thereof forms the unreacted compound layer 512 or the partially reacted compound layer 513.

As another method example of forming the active layer 51, there can be cited a method in which the perovskite compound layer 511 is once formed, and then heat treatment is performed thereon to selectively volatilize the A site material and the X site material, to form a stacked structure including the perovskite compound layer 511 and at least one of the unreacted compound layer 512 and the partially reacted compound layer 513.

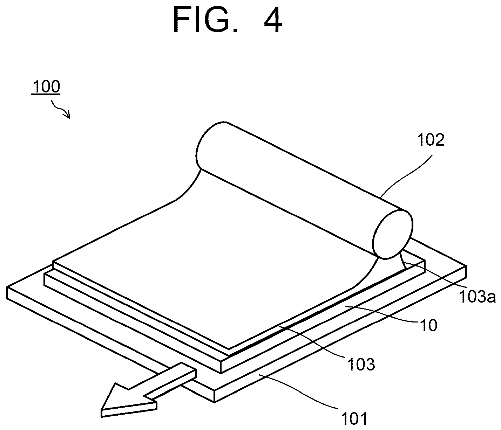

To apply the two-step method using the solution containing the precursor dissolved therein, method examples of coating the solution include a coating method using a meniscus coating apparatus as illustrated in FIG. 4. FIG. 4 is a view illustrating a configuration example of a meniscus coating apparatus. A coating apparatus 100 includes a transfer stage 101 on which a coating object 10 such as a substrate is arranged, a columnar coating head 102 arranged to face the transfer stage 101, and a coating solution supply mechanism that is not-illustrated in FIG. 4 and supplies a coating solution 103 between the coating object 10 and the coating head 102, and the coating apparatus 100 is configured to move the transfer stage 101 in a horizontal direction, which is indicated by an arrow mark, to the coating head 102 fixed in a position. The coating head 102 can be moved instead of the transfer stage 101, or the transfer stage 101 and the coating head 102 can be moved simultaneously in directions opposite to each other or in the same direction.

The coating apparatus 100 illustrated in FIG. 4 is configured to evenly supply the coating solution 103 between the coating object 10 and the coating head 102 to form a meniscus column 103a. The coating apparatus 100 is further configured to move transfer stage 101 in the horizontal direction with fixing the coating head 102 in the position. This can move the coating object 10 on the transfer stage 101 to the coating head 102 to apply and spread the coating solution using the coating head 102 onto the coating object.

A thickness of a solution film of the coating solution 103 can be adjusted in response to parameters such as a gap (Coating Gap) between the coating object 10 and the coating head 102, and a relative speed between the transfer stage 101 and the coating head 102 (Coating Speed).

The following description is about an example of the two-step method using the meniscus coating method. This method example includes: coating a solution containing the dissolved $BX_2$ compound and drying it to form the $BX_2$ compound layer; and then coating a solution containing the dissolved AX compound onto the $BX_2$ compound layer and drying it. This process causes a reaction between the $BX_2$ compound and the AX compound to partially or completely form of the perovskite compound ($ABX_3$). The partial reaction has a possibility of heating the compound layer to further react the $BX_2$ compound and the AX compound, and alternatively has a possibility of selectively volatilizing the A site and the X site material to cause a revers reaction (decomposition) of the perovskite compound ($ABX_3$) to reproduce the $BX_2$ compound.

The adjustment of a treatment condition such as a heating condition can form a single structure consisting of the perovskite compound layer 511, a stacked structure including the perovskite compound layer 511 and the unreacted compound layer 512, a stacked structure including the perovskite compound layer 511 and the partially reacted compound layer 513, or a stacked structure including the perovskite compound layer 511, the unreacted compound layer 512, and the partially reacted compound layer 513.

An another method of forming each structure includes adjusting a supply amount of the AX compound to be supplied onto the $BX_2$ compound layer. Method examples of adjusting the supply amount of the AX compound, include adjusting a solid content concentration of the solution containing the dissolved AX compound, and adjusting a thickness of the coating solution film of the solution containing the dissolved AX compound.

The following description is about a method of distinguishing the perovskite compound layer 511, the unreacted compound layer 512, or the partially reacted compound layer 513 from them. As described above, when the active layer 51 is represented by the composition formula $A_\alpha BX_\chi$, the perovskite compound layer 511 has a compound having a composition satisfying $0.95 \leq \alpha$, and $2.95 \leq \chi$. The unreacted compound layer 512 has a compound having a composition satisfying $\alpha \fallingdotseq 0$, and $\chi \fallingdotseq 2$. The partially reacted compound layer 513 has a compound having a composition satisfying $0.2 < \alpha < 0.4$, and $2.2 < \chi < 2.4$.

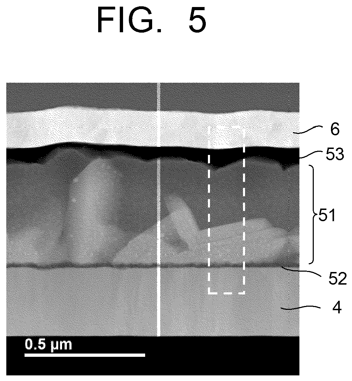

The following description is about a method of calculating $\alpha$ and $\chi$. This method first includes observing a cross section of the active layer 51 with a transmission electron microscope (TEM). FIG. 5 is a TEM image of a cross section including the active layer 51. FIG. 5 finds that the active layer 51 includes a plurality of regions having different contrasts. FIG. 5 illustrates an observation image observed by a high-angle annular dark-field scanning transmission electron microscope (HAADF STEM). The use of HAADF STEM causes the substrate electrode 4 side of the active layer 51 to be observed brighter, as illustrated in FIG. 5. In contrast, the use of a bright-field scanning transmission electron microscope (BF STEM) causes the substrate electrode 4 side of the active layer 51 to be observed darker.

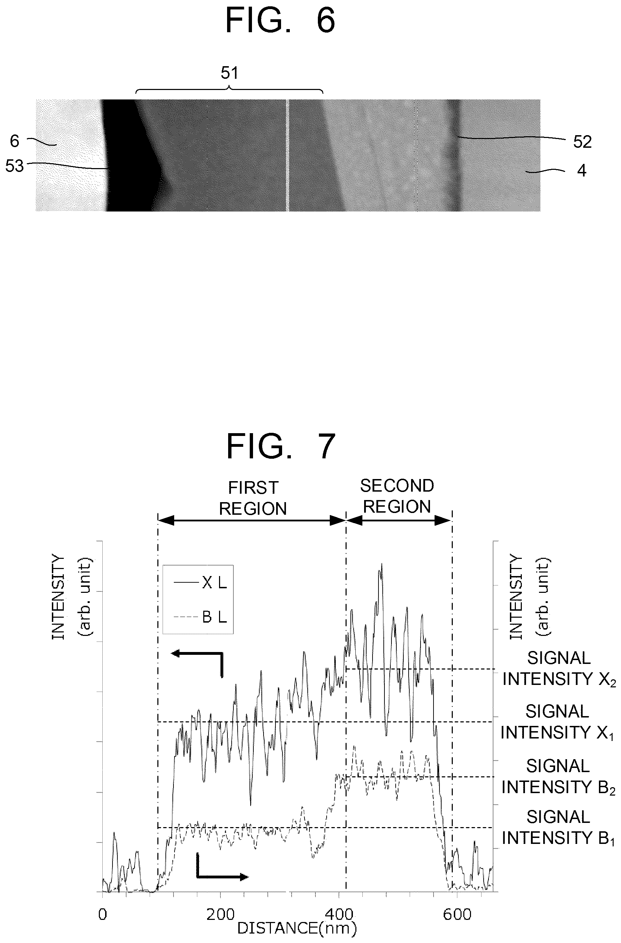

FIG. 6 is a view obtained when a portion indicated by a broken line in FIG. 5 is enlarged and turned counterclockwise by 90 degrees. Therefore, the left side corresponds to the counter electrode 6 side, and the right side corresponds to the substrate electrode 4 side. An element distribution in a film thickness direction of this cross section is analyzed by a line element analysis method. Examples of the element analysis method include an energy dispersive X-ray analysis (EDX, EDS).

FIG. 7 is a view illustrating a line element analysis result, and illustrating a line element analysis result of the active layer 51 formed by the two-step method that includes a first step of forming the $BX_2$ compound layer and a second step of forming the AX compound layer on the $BX_2$ compound layer. A solid line indicates a signal intensity distribution of the element X, and a broken line indicates a signal intensity distribution of the element B. As illustrated in FIG. 7, the element analysis signal intensity is greatly changed between different contrasts, so that a difference in contrasts can be quantified as a change in the signal intensities of the element X and the element B obtained through the element analysis.

The observed active layer 51 includes a first region and a second region here, the first region being defined by a region arranged on the counter electrode 6 side and having a first contrast, and the second region being defined by a region arranged on the substrate electrode 4 side and having a second contrast brighter than the first contrast. An average signal intensity of the element X in the first region is denoted by $X_1$, an average signal intensity of the element X in the second region is denoted by $X_2$, an average signal intensity of the element B in the first region is denoted by $B_1$, and an average signal intensity of the element B in the second region is denoted by $B_2$. Further, the following value $R_1$ is determined by $X_1 / B_1$ and the following value $R_2$ is determined by $X_2 / B_2$. Each of the values $X_1$, $X_2$, $B_1$ and $B_2$ cannot be represented by specific units, namely, it is represented by arbitrary units (arb.units), so that each of the values $R_1$, $R_2$ is also represented by arbitrary units.

$$R_1 = X_1 / B_1$$

$$R_2 = X_2 / B_2$$

One method example of forming the active layer 51 using the two-step method includes forming the $BX_2$ layer, and then coating the AX compound ink onto the layer. This activates a reaction between the $BX_2$ and AX compounds in a surface side of the $BX_2$ layer, namely, the first region side, and thus form a composition of an $ABX_3$ compound, namely, the composition substantially satisfying B : X = 1 : 3. Therefore, the value of $R_1 = X_1 / B_1$ represented by arbitrary units can be substantially 3. Accordingly, this is represented by the following formulas.

$$R1 : R2 = 3 : \chi$$

$$\chi = 3R_2 / R_1$$

If the reaction between the $BX_2$ and AX compounds has a reaction rate between A of the AX compound and the $BX_2$ compound and a reaction rate between X of the AX compound and the $BX_2$ compound, both reaction rates being substantially equal, the following formula is satisfied.

$$\alpha : \chi = 1 : 3$$

Therefore, $\alpha$ and $\chi$ can be determined by the following formulas.

$$\alpha = \chi / 3$$

$$\chi = 3X_2 / B_2 / (X_1 / B_1)$$

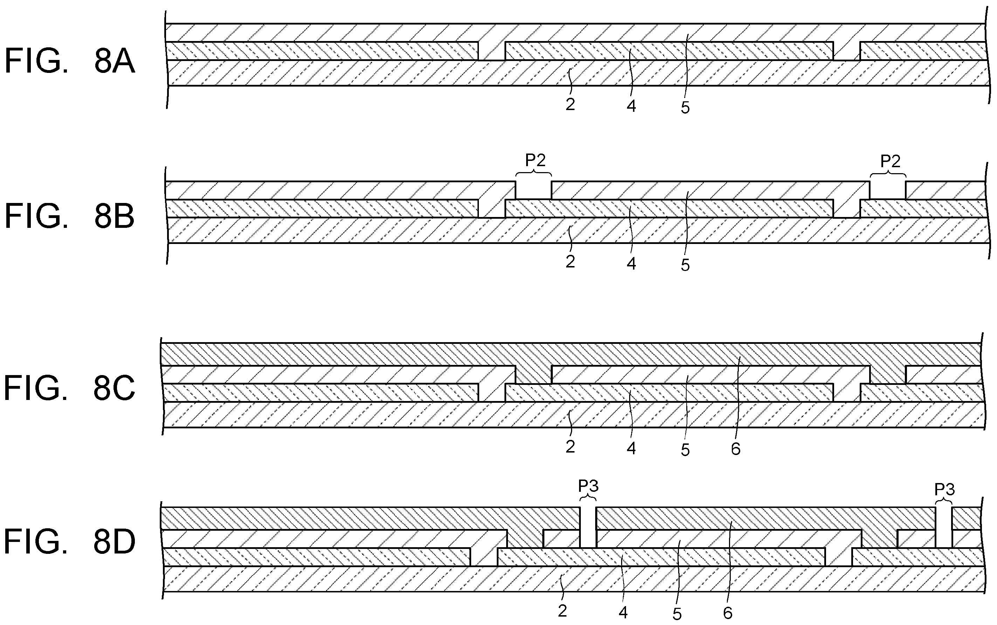

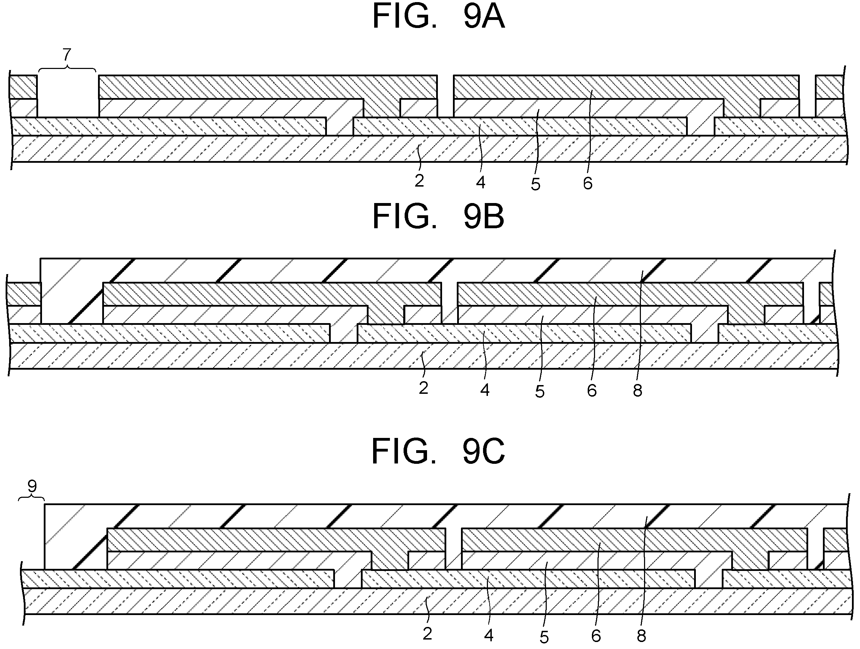

The next description is about a method example of manufacturing a photovoltaic module for describing a method example of manufacturing a photoelectric conversion device of an arrangement. The method example of manufacturing the photovoltaic module includes a plurality of steps for patterning a photoelectric conversion layer 5. FIGS. 8A to 8D and 9A to 9C are views for explaining the method example of manufacturing the photovoltaic module.

As illustrated in FIG. 8A, a photoelectric conversion layer 5 is formed on the whole surface of a substrate 2 on which a plurality of substrate electrodes 4 are formed. Next, as illustrated in FIG. 8B, parts of the photoelectric conversion layer 5 are patterned to form openings P2 from each of which a part of the substrate electrode 4 is exposed. This step is a step referred to as so-called P2 patterning.

Next, as illustrated in FIG. 8C, a counter electrode 6 is formed on the whole surface of the substrate 2. This step causes the exposed part of the substrate electrode 4 and the counter electrode 6 to be into contact with each other to form a so-called serial connection therebetween.

Next, as illustrated in FIG. 8D, a part of the stack of the photoelectric conversion layer 5 and the counter electrode 6 is patterned to form an openings P3 to separate the counter electrode 6 into a plurality of parts. This step is referred to as so-called P3 patterning.

Next, as illustrated in FIG. 9A, a part of the stack of the photoelectric conversion layer 5 and the counter electrode 6 is patterned to expose a part of the substrate electrode 4, to form an opening 7 being a sealing margin. The photoelectric conversion layer 5 may be deteriorated by moisture and oxygen in the atmosphere, so that the photoelectric conversion layer 5 is preferably covered by a sealing material 8 having a property of blocking moisture and oxygen in the atmosphere, as illustrated in FIG. 9B. The photoelectric conversion layer 5 is to prevent moisture and oxygen from entering not only the top but also an end of a film surface of the photoelectric conversion layer 5, so that the sealing material 8 is to extend to the outside of a film-forming region of the photoelectric conversion layer 5. This is to form the sealing margin.

Next, as illustrated in FIG. 9C, a part of the stack of the photoelectric conversion layer 5 and the counter electrode 6 is patterned to expose a part of the substrate electrode 4, to form an input/output pad 9. The input/output pad 9 of an example of a photovoltaics corresponds to an electrode pad for extracting generated electric power, and the input/output pad 9 of an example of a light emitting element corresponds to an electrode pad for inputting electric power to cause light emission.

The next description is about a method example of manufacturing the photoelectric conversion device 1 for describing a method example of manufacturing a photoelectric conversion device of an arrangement. Although the method example of manufacturing the photoelectric conversion device of the arrangement can be preferably applied for all steps of patterning the photoelectric conversion layer 5 illustrated in FIGS. 8A to 8D and 9A to 9C, this description is about an example of applying the manufacturing method to the P2 patterning step in detail.

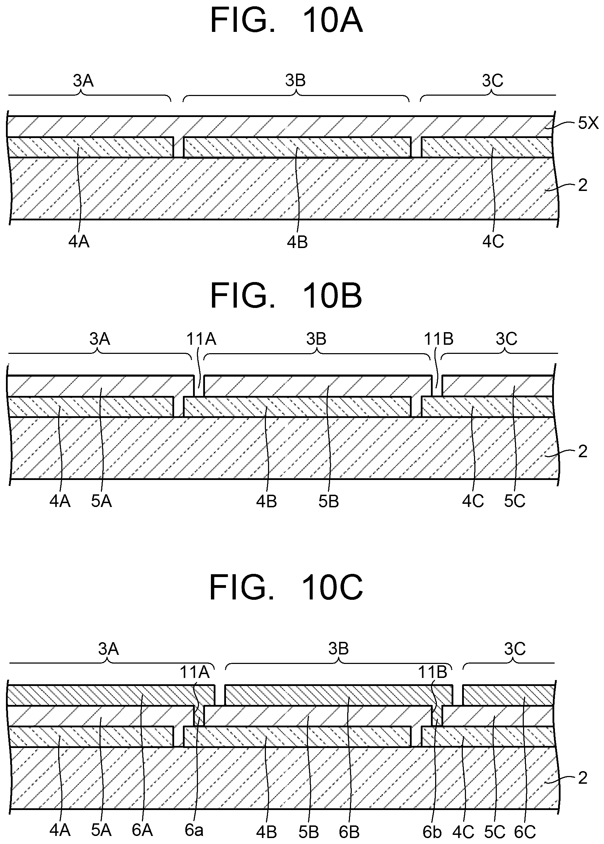

FIG. 10A to FIG. 10C are schematic views for explaining the method example of manufacturing the photoelectric conversion device 1. As illustrated in FIG. 10A, the method example of manufacturing the photoelectric conversion device 1 include forming substrate electrodes 4A, 4B, 4C corresponding to photoelectric conversion elements 3A, 3B, 3C on a substrate 2. The substrate electrode 4B is formed adjacent to the substrate electrode 4A, and is physically separated, namely, electrically insulated from the substrate electrode 4A. Similarly, the substrate electrode 4C is formed adjacent to the substrate electrode 4B, and is separated, namely, electrically insulated from the substrate electrode 4B. A photoelectric conversion layer 5X is formed above the substrate 2 to cover these substrate electrodes 4A, 4B, 4C. The photoelectric conversion layer 5X is formed on the whole surface to cover all of the substrate electrodes 4A, 4B, 4C.

Next, as illustrated in FIG. 10B, the photoelectric conversion layer 5X is scribed to divide the photoelectric conversion layer 5X into a plurality of parts corresponding to the respective photoelectric conversion elements 3A, 3B, 3C, resulting in forming dividing grooves 11A, 11B. The dividing grooves 11A, 11B dividing the photoelectric conversion layer 5X are formed by a scribing method such as mechanical scribing or laser scribing. The division of the photoelectric conversion layer 5X into the plural parts by the scribe grooves (dividing grooves) 11A, 11B, can form the photoelectric conversion layers 5A, 5B, 5C corresponding to the plural photoelectric conversion elements 3A, 3B, 3C. The dividing grooves 11A, 11B define regions for connections electrically connecting the counter electrodes 6A, 6B of the photoelectric conversion elements 3A, 3B to the substrate electrodes 4B, 4C of the adjacent photoelectric conversion elements 3B, 3C. Therefore, the dividing grooves 11A, 11B expose the surfaces of the substrate electrodes 4B, 4C.

As illustrated in FIG. 10C, the counter electrodes 6A, 6B, 6C corresponding to the respective plural photoelectric conversion elements 3A, 3B, 3C are formed on the photoelectric conversion layers 5A, 5B, 5C. When forming the counter electrodes 6A, 6B of the photoelectric conversion elements 3A, 3B, parts of the counter electrodes 6A, 6B (conductive portions 6a, 6b) are filled in the dividing grooves 11A, 11B provided between the photoelectric conversion elements 3A, 3B and the adjacent photoelectric conversion elements 3B, 3C. This electrically connects the counter electrodes 6A, 6B of the photoelectric conversion elements 3A, 3B to the substrate electrodes 4B, 4C of the adjacent photoelectric conversion elements 3B, 3C via the conductive portions 6a, 6b filled in the dividing grooves 11A, 11B. The intermediate layer 53 can be partly filled in the dividing grooves 11A, 11B.

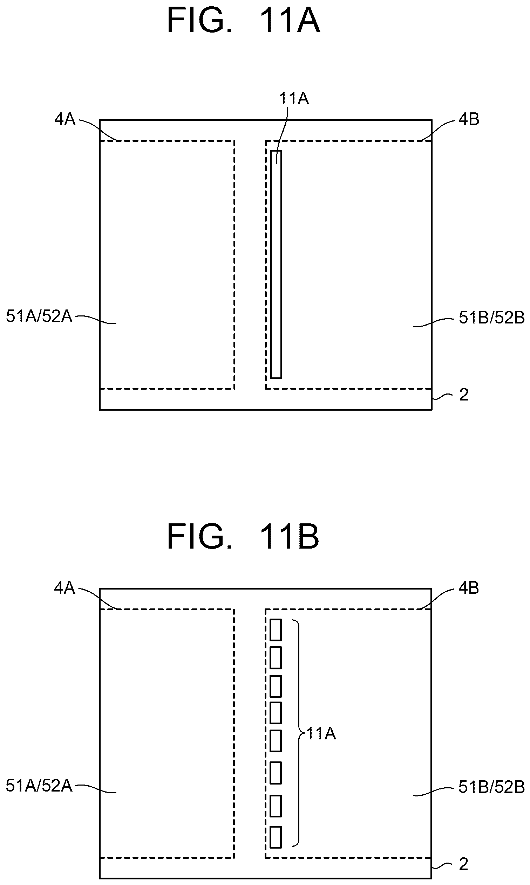

FIG. 11A and FIG. 11B are plan views each explaining a method example of manufacturing the photoelectric conversion device 1. As illustrated in FIG. 11A, the dividing groove 11A can be continuously formed in a solid line shape, or it can also be formed intermittently in a broken line shape or a dotted line shape, as illustrated in FIG. 11B.

An example of common manufacturing steps includes exposing surfaces of the substrate electrodes 4B, 4C in the dividing grooves 11A, 11B, to electrically connect the counter electrodes 6A, 6B of the photoelectric conversion elements 3A, 3B to the substrate electrodes 4B, 4C of the adjacent photoelectric conversion elements 3B, 3C. The dividing grooves 11A, 11B can be formed by mechanical scribing using a cutting tool or laser scribing. When mechanically scribing the photoelectric conversion layer 5X, the application of a pressure for surely exposing the surfaces of the substrate electrodes 4B, 4C, may crack the substrate electrodes 4B, 4C made of a hard and brittle conductive metal oxide. Especially a use of a soft substrate made of an organic material to the substrate 2, may deform the soft substrate pressed by the cutting tool, resulting in further cracking the substrate electrodes 4B, 4C. The use of the soft substrate further may be scribed.

On the other hand, the conventional manufacturing step can lower the pressure in mechanical scribing to prevent the substrate electrodes 4B, 4C from cracking, but this increase the remainder of parts of the photoelectric conversion layer 5X in the dividing grooves 11A, 11B. If the soft and viscous photoelectric conversion layer 5X such as the perovskite compound on the hard substrate electrodes 4B, 4C is tried to be mechanically scribed, parts of the photoelectric conversion layer 5X are likely to remain in the dividing grooves 11A, 11B. If the parts of the photoelectric conversion layer 5X remain in the dividing grooves 11A, 11B, electric resistance (series wiring resistance) between the counter electrodes 6A, 6B of the photoelectric conversion elements 3A, 3B and the substrate electrodes 4B, 4C of the adjacent photoelectric conversion elements 3B, 3C increases, resulting in reducing photoelectric conversion efficiency.

The series wiring resistance between the counter electrodes 6A, 6B of the photoelectric conversion elements 3A, 3B and the substrate electrodes 4B, 4C of the adjacent photoelectric conversion elements 3B, 3C is preferably 5 Ω or less, and more preferably 2.5 Ω or less. A photovoltaics is determined by irradiating light to obtain an I-V curve and then using the I-V curve to obtain characteristic values such as short-circuit current density Jsc, open circuit voltage Voc, fill factor FF, series resistance Rs, and parallel resistance Rsh. Photoelectric conversion efficiency has a higher value as the series resistance Rs is lower. Since the series resistance Rs includes the series wiring resistance, the series wiring resistance is preferably as low as possible. To obtain practical photoelectric conversion efficiency in a wide variety of applications, the series wiring resistance per unit area is preferably 30 $\Omega \cdot cm^2$ or less, and more preferably 15 $\Omega \cdot cm^2$ or less. Further, to obtain a generally practical power generation amount in a wide variety of applications, a power generation area needs to be 3 $cm^2$ or more. The series resistance Rs calculated in view of these points is preferably 10 Ω or less, and more preferably 5 Ω or less. When a ratio occupied by the series wiring resistance in the series resistance Rs is aimed to be reduced to half or less, the series wiring resistance is preferably 5 Ω or less, and more preferably 2.5 Ω or less. The above series wiring resistance can be achieved by applying the following method of forming the scribe grooves of the arrangement and the scribe grooves based on the method.

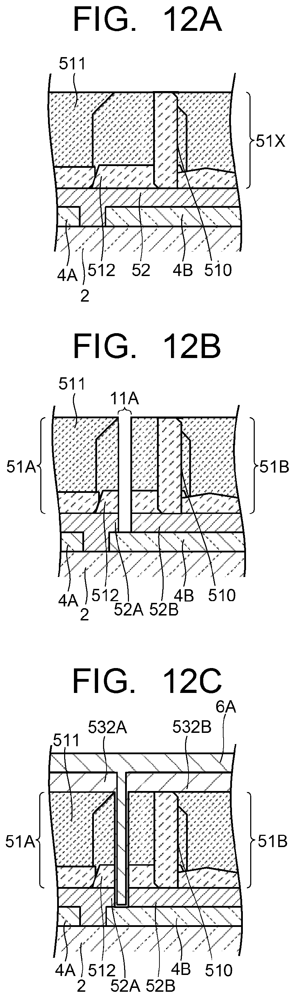

The following structure and steps are applied for forming the dividing grooves 11A, 11B, and the connections 13A, 13B in the dividing grooves 11A, 11B, in the method of manufacturing the photoelectric conversion device 1 of the arrangement. The following description is about a step of connecting the photoelectric conversion elements 3 in the method of manufacturing the photoelectric conversion device 1 of the arrangement and the configuration of the connections with reference to FIG. 12A to FIG. 12C. FIG. 12A to FIG. 12C are sectional views illustrating the step of connecting the photoelectric conversion elements 3. Although FIG. 12A to FIG. 12C illustrate the step of connecting the photoelectric conversion element 3A and the photoelectric conversion element 3B adjacent thereto, the step of connecting the photoelectric conversion element 3B and the photoelectric conversion element 3C adjacent thereto is also done in the same method. The same applies to a case where the photoelectric conversion device 1 has four or more photoelectric conversion elements 3, and the adjacent photoelectric conversion elements 3 are serially connected in sequence by the same step.

As illustrated in FIG. 12A, an active layer 51X is formed above the substrate 2 so as to entirely cover the substrate electrode 4A and the substrate electrode 4B. Next, as illustrated in FIG. 12B, the active layer 51X is scribed to form the dividing groove 11A, to expose the surface of the substrate electrode 4B. By forming the dividing groove 11A to divide the active layer 51X into a plurality of parts, active layers 51A, 51B corresponding to the photoelectric conversion elements 3A, 3B are formed. The dividing groove 11A is formed by the mechanical scribing or the laser scribing of the active layer 51X, as described above.

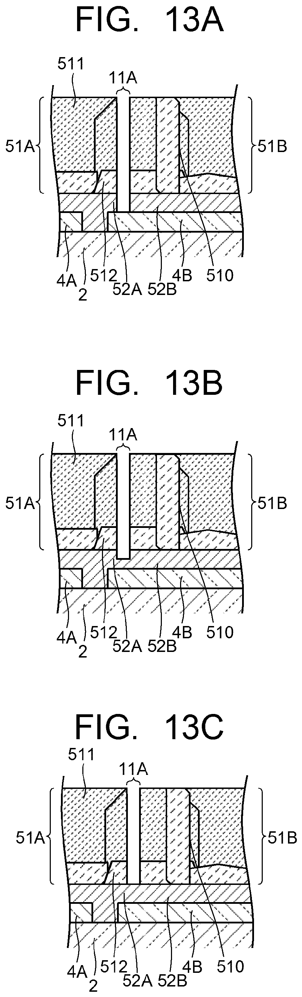

When the intermediate layer 52 is formed under the active layer 51X, the dividing groove 11A can form three kinds of structures. As illustrated in FIG. 13A, the dividing groove 11A can be formed by scribing both the intermediate layer 52 and the active layer 51X. When the intermediate layer 52 has sufficient conductivity, the intermediate layer 52 can be scribed to form the remainder of a part of the intermediate layer 52ed as illustrated in FIG. 13B, or can be scribed to form the remainder of all of the intermediate layer 52 as illustrated in FIG. 13C. Concretely, the remainder of a part or all of the intermediate layer 52 can be formed by reducing a thickness of the intermediate layer 52 or using a material with high conductivity to obtain the series wiring resistance.

When the intermediate layer 53 is formed on the active layer 51X, the dividing groove 11A is formed by scribing a multilayer film of the active layer 51X and the intermediate layer 53.

In the photoelectric conversion device 1 and the manufacturing method thereof, the active layer 51X is formed to have a stacked structure including the perovskite compound layer 511 and at least one of the unreacted compound layer 512 and the partially reacted compound layer 513. The perovskite compound is soft and has high viscosity. In contrast, the unreacted compound and the partially reacted compound have relatively low viscosity. Therefore, a presence of the unreacted compound layer 512 or the partially reacted compound layer 513 between the perovskite compound layer 511 and the substrate electrode 4, enables to easy exposure of the surface of the substrate electrode 4 without any residue in the scribing step. Further, the unreacted compound and the partially reacted compound are mechanically slippery due to their low viscosity. This prevents the substrate electrode 4 and the substrate 2 from cracking and scrapping even hard setting a scribing blade on the unreacted compound layer 512 or the partially reacted compound layer 513 in the mechanical scribing step. The unreacted compound layer 512 or the partially reacted compound layer 513 is to be provided only to at least a scribe part, to achieve the above effect.

An average thickness of the unreacted compound layer 512 and the partially reacted compound layer 513 is preferably 10 nm or more and 500 nm or less, and more preferably 30 nm or more and 300 nm or less. If the setting surface to the scribing blade has a surface roughness of less than 30 nm, this may increase its forming cost. If the unreacted compound layer 512 or the partially reacted compound layer 513 has an average film thickness of less than 30 nm, this may cause a protrusion of the scribing blade to be directly in contact with the substrate electrode 4 to damage the substrate electrode 4. The unreacted compound layer 512 or the partially reacted compound layer 513 may have the light absorbing property, the charge generating property, and the charge selectivity, each being inferior to those of the perovskite compound layer 511. Therefore, if the average thickness of the unreacted compound layer 512 and the partially reacted compound layer 513 exceeds 300 nm, this cannot overlook the reduction in the photoelectric conversion property.

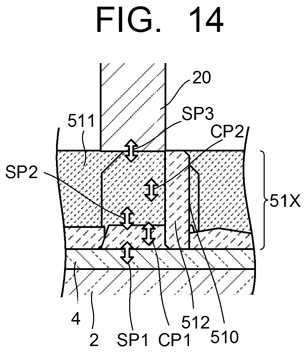

FIG. 14 is a view illustrating a state where the active layer 51X is mechanically scribed with a scribing blade 20. Arrows in FIG. 14 indicate five forces having an influence on the scribing properties, out of forces acting during the mechanical scribing. Concretely, the forces are an adhesion force SP1 acting between the substrate electrode 4 and the unreacted compound layer 512 or the partially reacted compound layer 513, a cohesive force CP1 of the unreacted compound layer 512 or the partially reacted compound layer 513, an adhesion force SP2 acting between the unreacted compound layer 512 or the partially reacted compound layer 513 and the perovskite compound layer 511, a cohesive force CP2 of the perovskite compound layer 511, and an adhesion force SP3 acting between the perovskite compound layer 511 and the scribing blade 20. When exposing the surface of the substrate electrode 4, it is more advantageous that the adhesion force SP1 out of the five forces is the weakest.

In the photoelectric conversion device 1 and the manufacturing method thereof, the use of the unreacted compound layer 512 or the partially reacted compound layer 513 having the low viscosity, weakens the adhesion force SP1 between the substrate electrode 4 and the unreacted compound layer 512 or between the substrate electrode 4 and the partially reacted compound layer 513. This can remove the unreacted compound layer 512 or the partially reacted compound layer 513 from an interface between the layer and the substrate electrode 4 weakened in the adhesion force SP1, and thus expose the surface of the substrate electrode 4 without any residue in mechanically scribing the active layer 51X with the scribing blade 20. Therefore, this enhances electrical connectivity between the counter electrode 6A of the photoelectric conversion element 3A and the substrate electrode 4B of the photoelectric conversion element 3B. Further, the weakness of the adhesion force SP1 between the substrate electrode 4 and the unreacted compound layer 512 or the partially reacted compound layer 513, improve the scribability of the laser scribing. This enhances electrical connectivity between the counter electrode 6A of the photoelectric conversion element 3A and the substrate electrode 4B of the photoelectric conversion element 3B.

Next, as illustrated in FIG. 12C, intermediate layers 532A, 532B and the counter electrodes 6A, 6B corresponding to the respective photoelectric conversion elements 3A, 3B are sequentially formed on the active layers 51A, 51B. When forming the intermediate layer 532A and the counter electrode 6A of the photoelectric conversion element 3A, a part of the intermediate layer 532A and a part of the counter electrode 6A (conductive portion 6a) are filled in the dividing groove 11A provided between the photoelectric conversion element 3A and the adjacent photoelectric conversion element 3B. This connects the counter electrode 6A of the photoelectric conversion element 3A to the substrate electrode 4B of the adjacent photoelectric conversion element 3B via a connection 13A having the conductive portion 6a filled in the dividing groove 11A. The intermediate layer 532A in the dividing groove 11A is not essential, and can be formed only in a region other than the dividing groove 11A.

The photoelectric conversion device 1 and the manufacturing method thereof, can prevent a part of the active layer 51 from remaining in the dividing groove 11 without cracking the substrate electrode in the scribing. Therefore, this can improve electrical connectivity between the adjacent photoelectric conversion elements 3. Concretely, This can reduce electrical resistance of the connection 13A connecting the counter electrode 6A of the photoelectric conversion element 3A and the substrate electrode 4B of the adjacent photoelectric conversion element 3B, namely, the series wiring resistance, down to 5 $\Omega$ or less and further 2.5 $\Omega$ or less, as described above. An increase in the series wiring resistance between the photoelectric conversion elements 3 causes a reduction in photoelectric conversion efficiency of the photoelectric conversion device 1. The photoelectric conversion device 1 and the manufacturing method thereof, can improve the photoelectric conversion efficiency. Even the number of the serially connected photoelectric conversion elements 3 is increased, the reduction of a probability of an increase in the connection resistance between the adjacent photoelectric conversion elements 3, can enhance the photoelectric conversion efficiency as the whole device.

When SP3 is the weakest in FIG. 14, the scribing blade slips to prevent removal by scribing almost at all. An example of a step in which at least a counter electrode is only required to be removed by patterning (P3 patterning), cannot not only expose a surface of the substrate electrode, but also remove the counter electrode. Therefore, the method of manufacturing the present arrangement capable of obtaining the effect that SP1 is the weakest, is suitable also in the P3 patterning.

EXAMPLES

(Reference Example 1)

A plurality of 150 nm-thick ITO films were formed as substrate electrodes, on a polyethylene naphthalate (PEN) substrate with a 125 $\mu$m thickness. The number of the ITO films formed was eight corresponding to the number of photoelectric conversion elements installed. That is, they were formed so as to correspond to an eight-series module.

Next, poly(3,4-ethylenedioxythiophene)/poly(4-styrenesulfonate) (PEDOT/PSS) was formed as an intermediate layer on the substrate electrode side. The film formation of the PEDOT-PSS was performed by using Clevios AI4083 manufactured by Heraeus K.K., with the use of a meniscus coating apparatus.

Next, an active layer was formed by using the meniscus coating apparatus and the two-step method. As a coating solution in the first step, one obtained by dissolving $PbI_2$ in a mixed solvent of dimethylformamide (DMF) and dimethyl sulfoxide (DMSO) in a 1 : 1 ratio was used. As a coating solution in the second step, one obtained by dissolving $CH_3NH_3I$ (MAI) in isopropyl alcohol (IPA) was used. As a result of performing evaluation separately, a solid film thickness of $PbI_2$ was about 250 nm. A solid content concentration of MAI was set to 0.3 M (molar). After finishing the two-step, heat treatment was performed at 120°C for 5 minutes, to form the active layer.

Next, as a first intermediate layer on the counter electrode side, PC60BM ([6,6]-phenyl-C61-butyric acid methylester) was deposited. As a solvent of a PC60BM ink, monochlorobenzene was used. After the PC60BM ink was applied, it was naturally dried. Its film thickness was set to about 50 nm.

Next, mechanical scribing was performed. As a scribing tool, an 80 $\mu$m-wide cutting tool having a rectangular tip was used. In the mechanical scribing, the scribing tool was pressed by a suspension mechanism using a spring having a predetermined force and was scanned. When a pressure of the scribing tool was within a range of 0.002 to 0.2 mN/$\mu$m$^2$, three layers of the PC60BM layer, the active layer, and the PEDOT·PSS layer were scraped with almost no residue, and it was possible to expose the ITO films. Further, the scribing did not go so far as to cause cracking of the ITO films and to scrape the ITO films and the PEN substrate. When the pressure was reduced to 0.001 mN/$\mu$m$^2$, the residue was seen at some part. When the pressure was increased to 0.3 mN/$\mu$m$^2$, the PEN substrate was also scraped.

Next, as a second intermediate layer on the counter electrode side, BCP (2,9-dimethyl-4,7-diphenyl-1,10-phenanthroline) with an about 20 nm thickness was deposited by vacuum evaporation. Next, as a counter electrode, an about 150 nm-thick film of Ag was formed by vacuum evaporation. By using a common deposition mask on the two layers, eight second intermediate layers and eight counter electrodes were formed corresponding to the number of the photoelectric conversion elements installed. Consequently, an eight-series module structure was formed. An area of one photoelectric conversion element is about 2.8 cm$^2$.

Regarding the aforesaid eight-series photoelectric conversion device module, the resistance of series wiring parts passing through mechanical scribe parts (series wiring resistance) was measured. In the measurement of the series wiring resistance, anode wirings were connected to counter electrode-side contact pads, and cathode wirings were connected to the counter electrodes. When the polarity was reversed, substantially the same values were also obtained in all of the following measurement results of the series wiring resistance. When measuring the series wiring resistance, the wiring positions are preferably set at positions as close to the series wiring parts as possible, so as not to be influenced by a sheet resistance of the substrate electrode and the counter electrode as much as possible.

The series wiring resistance at eight places of the eight-series module was measured. In the photoelectric conversion device module of the reference example 1, the series wiring resistance was 0.3 $\Omega$ at all of eight places, when the pressure of the scribing tool was within a range of 0.002 to 0.2 mN/$\mu$m$^2$. This value is a low and thus favorable value giving almost no adverse effect on photoelectric conversion efficiency in the operation as practical photovoltaics in a wide variety of applications as previously described. As described above, a favorable photoelectric conversion device module with a low series wiring resistance was obtained.

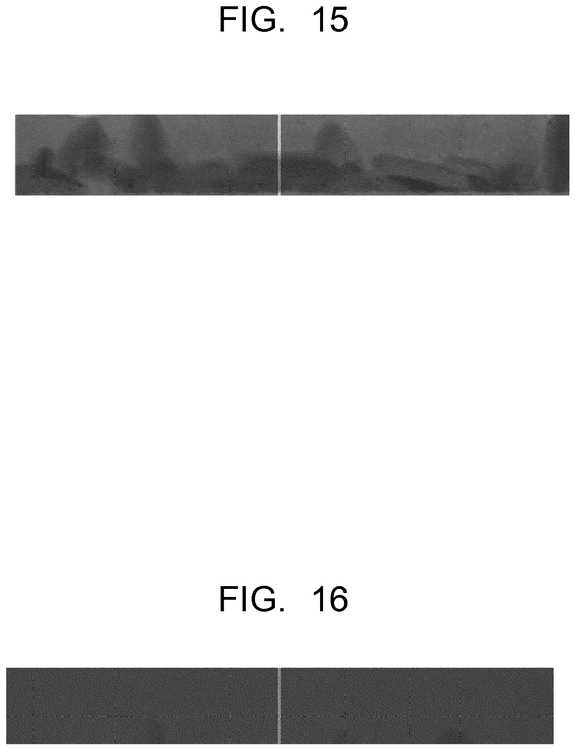

When a cross section of the produced module was observed by TEM, two kinds of compounds with different contracts existed in the active layer, as illustrated in FIG. 15. the observation image illustrated in FIG. 15 is an observation image based on the BF STEM method, different from an observation image based on the HAADF STEM method illustrated in FIG. 5, so that gradation of the contrasts is reversed.

When an element analysis of the active layer was performed by using the aforementioned method, it was confirmed that, when a composition ratio of the compound layer on the counter electrode side of the active layer was regarded as A : B : X = 1 : 1 : 3, a composition ratio of the compound layer on the substrate electrode side of the active layer was approximately A : B : X = 0 : 1 : 2, and thus an unreacted compound layer was formed.

Photoelectric conversion efficiency of the produced photoelectric conversion device module was measured by using a solar simulator providing AM 1.5 G and 1000 W/m$^2$, and the result was 9.6%.

(Example 2)

A photoelectric conversion device module was produced in the same manner as in the reference example 1, except that the solid content concentration of MAI was increased to 0.4 M (molar) in the second step.

When an element analysis of the active layer was performed, it was confirmed that, when a composition ratio of the compound layer on the counter electrode side of the active layer was regarded as A : B : X = 1 : 1 : 3, a composition ratio of the compound layer on the substrate electrode side of the active layer was approximately A : B : X = 0.24 : 1 : 2.24, and thus a partially reacted compound layer, different from the unreacted compound layer in the reference example 1, was formed.

Evaluation results regarding the scribing properties and the series wiring resistance were similar to those of the example 1, and thus a favorable photoelectric conversion device module with a low series wiring resistance was obtained.

When photoelectric conversion efficiency was measured, the result was 12.7%, and thus the property better than that of the reference example 1 was obtained. Although the compound layer on the substrate electrode side was the unreacted compound layer ($BX_2$) in the reference example 1, it was the partially reacted compound layer ($A_{0.24}BX_{2.24}$) in the example 2. The photoelectric conversion property of the photoelectric conversion device module can be considered to depend on the photoelectric conversion property and the series wiring property of a unit cell. Since the series wiring characteristics were similar between the reference example 1 and the example 2, it can be considered that a difference occurred in the photoelectric conversion property of the unit cell. Concretely, it can be considered that the reason thereof is because the partially reacted compound layer whose composition is closer to that of the perovskite compound layer ($ABX_3$) has a better photoelectric conversion property. More concretely, it can be considered that the reason thereof is because the partially reacted compound layer is superior in terms of the light absorbing property, the charge generating property, and the charge transport selectivity.

(Example 3)

A photoelectric conversion device module was produced in the same manner as in the examples 1 and 2, except that the solid content concentration of MAI was increased to 0.42 M (molar) in the second step.

When an element analysis of the active layer was performed, it was confirmed that, when a composition ratio of the compound layer on the counter electrode side of the active layer was regarded as A : B : X = 1 : 1 : 3, a composition ratio of the compound layer on the substrate electrode side of the active layer was approximately A : B : X = 0.35 : 1 : 2.35, and thus a partially reacted compound layer was formed.

Evaluation results regarding the scribing properties and the series wiring resistance were similar to those of the examples 1 and 2, and thus a favorable photoelectric conversion device module with a low series wiring resistance was obtained. When photoelectric conversion efficiency was measured, the result was 12.9%, which was approximately the same as that of the example 2.

(Reference Example 4)

A photoelectric conversion device module was produced in the same manner as in the examples 1 to 3, except that the solid content concentration of MAI was further increased to 0.5 M (molar) in the second step.

When an element analysis of the active layer was performed, it was confirmed that, when a composition ratio of the compound layer on the counter electrode side of the active layer was regarded as A : B : X = 1 : 1 : 3, a composition ratio of the compound layer on the substrate electrode side of the active layer was approximately A : B : X = 0.90 : 1 : 2.90, and thus a partially reacted compound layer was formed.

When the series wiring resistance of the series wiring parts at eight places was measured, at a place with the lowest series wiring resistance, the value was $0.3\,\Omega$, similarly to the examples 1 to 3, and thus a favorable series wiring was formed. However, there was also a place where the series wiring resistance was $18\,\Omega$, so that the scribing properties were somewhat lowered when compared to the examples 1 to 3.

When photoelectric conversion efficiency was measured, the result was 10.7%, and thus it was possible to obtain conversion efficiency at a practical level as a photovoltaics.

(Comparative Example 1)

A photoelectric conversion device module was produced in the same manner as in the examples 1 to 4, except that the solid content concentration of MAI was further increased to 0.6 M (molar) in the second step.

When an element analysis of the active layer was performed, it was confirmed that, when a composition ratio of the compound layer on the counter electrode side of the active layer was regarded as A : B : X = 1 : 1 : 3, a composition ratio of the compound layer on the substrate electrode side of the active layer was approximately A : B : X = 0.96 : 1 : 2.96, and thus not the unreacted compound layer in the reference example 1 and the partially reacted compound layer in the examples 2 to 4, but a perovskite compound layer was formed.

Mechanical scribing was performed in the same manner as in the (reference) examples 1 to 4. Even when the pressure of the scribing tool was adjusted within a range of 0.001 to 0.2 mN/$\mu$m$^2$, the residue was generated, and it was not possible to sufficiently expose the ITO film. Further, when the pressure was increased to 0.3 mN/$\mu$m$^2$, the PEN substrate was also scraped.

A series wiring resistance of the photoelectric conversion device module produced through series wiring in a state where the residue was generated, was a high value of 770 to 850 Q, and it was a value apparently exerting an adverse effect when obtaining a favorable photoelectric conversion device module. When photoelectric conversion efficiency was measured, the result was 2.2%, and thus it was not possible to obtain conversion efficiency at a practical level.

(Comparative Example 2)

A photoelectric conversion device module was produced in the same manner as in teh reference example 1 and examples 2 to 4 and the comparative example 1, except that the coating method of the perovskite compound layer was changed from the meniscus coating to spin coating and the solid content concentration of MAI was reduced to 0.05 M.
When a cross section of the produced module was observed by TEM, as illustrated in FIG. 16, there was no difference in contracts in the active layer, different from the perovskite compound layer produced through the meniscus coating.
The mechanical scribing was performed, in which even when the pressure of the scribing tool was adjusted within a range of 0.001 to 0.2 mN/$\mu$m$^2$, the residue was generated, and it was not possible to sufficiently expose the ITO film. Further, when the pressure was increased to 0.3 mN/$\mu$m$^2$, the PEN substrate was also scraped.
A series wiring resistance of the photoelectric conversion device module produced through series wiring in a state where the residue was generated, was a high value of 520 $\Omega$ or more, and it was a value apparently exerting an adverse effect when obtaining a favorable photoelectric conversion device module.
When photoelectric conversion efficiency was measured, the result was 0.1%, and thus it was not possible to obtain conversion efficiency at a practical level. It can be estimated that this is because the series wiring resistance is high, and other than that, the solid content concentration of MAI is excessively low, so that the reaction with PbI$_2$ does not occur almost at all and almost all of the active layer is not reacted up to when it is turned into the perovskite compound layer.
The reason why the scribing could not be performed favorably, can be explained by using the aforementioned FIG. 14. To perform scribing, at least the adhesion force SP1 is required to be smaller than the adhesion force SP3 in FIG. 14, but, in the active layer of this comparative example, no difference was generated in the compositions between the substrate electrode side and the counter electrode side, and thus a significant difference was not generated between the adhesion force SP 1 and the adhesion force SP3, which can be considered as the reason.

(Reference Example 5)

A photoelectric conversion device module was produced in the same manner as in the comparative example 2, except that the solid content concentration of MAI was increased to 0.2 M.
When a cross section of the produced module was observed by TEM, two kinds of compounds with different contrasts existed in the active layer, different from the comparative example 2.
When an element analysis of the active layer was performed, it was confirmed that, when a composition ratio of the compound layer on the counter electrode side of the active layer was regarded as A : B : X = 1 : 1 : 3, a composition ratio of the compound layer on the substrate electrode side of the active layer was approximately A : B : X = 0.92 : 1 : 2.92, and thus a partially reacted compound layer was formed.
When the series wiring resistance of the series wiring parts at eight places was measured, at a place with the lowest series wiring resistance, the value was 0.3 $\Omega$, and thus a favorable series wiring was formed. However, there was also a place where the series wiring resistance was 20 Q. When photoelectric conversion efficiency was measured, the result was 8.5%.

(Comparative Example 3)

Three kinds of photoelectric conversion device modules were produced in the same manner as in the comparative example 2 and the reference example 5, except that the solid content concentration of MAI was changed to 0.3, 0.4, and 0.5 M.
When a cross section of each of the produced modules was observed by TEM, there was no difference in contrasts in the active layer. Although FIG. 16 illustrates, as one example, the cross section of the module in which the solid content concentration of MAI was 0.05 M, also in cases of the other solid content concentrations, it was common that there was no difference in contrasts, although the depth of color was different.
The mechanical scribing was performed, in which even when the pressure of the scribing tool was adjusted within a range of 0.001 to 0.2 mN/$\mu$m$^2$, the residue was generated, and it was not possible to sufficiently expose the ITO film. Further, when the pressure was increased to 0.3 mN/$\mu$m$^2$, the PEN substrate was also scraped.
A series wiring resistance of the photoelectric conversion device module produced through series wiring in a state where the residue was generated, was a high value of 1200 $\Omega$ at the lowest, and it was a value apparently exerting an adverse effect when obtaining a favorable photoelectric conversion device module. When photoelectric conversion efficiency was measured, the results was 1.5% at the maximum, and thus it was not possible to obtain conversion efficiency at a practical level.

Based on the results of the comparative examples 2, 3, and the reference example 5 in each of which the coating method was changed from the meniscus coating to the spin coating, it was found out that the solid content concentration of MAI for obtaining the practical conversion efficiency is approximately 0.05 to 0.2 M, which is a range narrower than a range of 0.3 to 0.5 M being an appropriate range in the case of the meniscus coating.

As described above, although the unreacted compound layer and the partially reacted compound layer can be formed also by the spin coating, in the case of the meniscus coating, the unreacted compound layer and the partially reacted compound layer are likely to be formed even if the solid content concentration of MAI varies in a wider range, which leads to improvement of the scribing properties, resulting in that it was possible to provide the photoelectric conversion device module with high conversion efficiency.

While certain arrangements of the present invention have been described, these arrangements have been presented by way of example only, and are not intended to limit the scope of the inventions. The scope of the present invention is defined by the appended set of claims.

**Claims**

1. A **photoelectric** conversion device (1), comprising:

   a substrate (2);
   a first photoelectric conversion element (3A) including

   a first substrate electrode (4A) arranged on the substrate (2),
   a first active layer arranged on the first substrate electrode (4A), and
   a first counter electrode (6A) arranged on the first active layer;

   a second photoelectric conversion element (3B) including

   a second substrate electrode (4B) arranged on the substrate (2) and physically separated from the first substrate electrode (4A),
   a second active layer arranged on the second substrate electrode (4B), and a second counter electrode (6B) arranged on the second active layer; and

   a connection (13A, 13B) including a groove (11A, 11B) and a conductive portion, the groove (11A, 11B) penetrating through the second active layer from a surface of the second active layer to expose a surface of the second substrate electrode (4B) from the second active layer, the conductive portion including a part of the first counter electrode (6A) filled in the groove (11A, 11B), and the connection (13A, 13B) electrically connecting the first counter electrode (6A) and the second substrate electrode (4B) via the conductive portion, wherein:

   the second active layer is represented by a composition formula: $A_\alpha BX_\chi$, where A denotes at least one cation selected from the group consisting of monovalent cations, B denotes at least one cation selected from the group consisting of bivalent cations, and X denotes at least one ion selected from the group consisting of monovalent halogen ions; and
   the second active layer has a first and a second compound layer, the first compound layer containing a first compound satisfying $0.95 \leq \alpha$, and $2.95 \leq \chi$, the second **compound** layer being arranged between the first compound layer and the second substrate electrode (4B), and the second compound layer containing a second compound satisfying $0.2 < \alpha < 0.4$, and $2.2 < \chi < 2.4$.

2. The device according to claim 1, wherein
   the substrate (2) contains at least one organic material selected from the group consisting of polyethylene, polyethylene terephthalate, polyethylene naphthalate, polyimide, polyamide, polyamide-imide, and a liquid crystal polymer.

3. The device according to claim 1, wherein
   the second substrate electrode (4B) contains at least one conductive metal oxide selected from the group consisting of indium oxide, zinc oxide, tin oxide, indium tin oxide, fluorine-doped tin oxide, gallium-doped zinc oxide, aluminum-doped zinc oxide, indium-zinc oxide, and indium-gallium-zinc oxide.

4. The device according to claim 1, wherein:

the first photoelectric conversion element (3A) includes a first intermediate layer arranged between the first active layer and the first substrate electrode; and

the second photoelectric conversion element (3B) includes a second intermediate layer arranged between the second active layer and the second substrate electrode.

5. A method of manufacturing a photoelectric conversion device, comprising:

forming first and second substrate electrodes (4A, 4B) onto a substrate (2);

forming first and second active layers onto the first and second substrate electrodes (4A, 4B), respectively;

forming a groove (11A, 11B) penetrating through the second active layer from a surface of the second active layer to expose a surface of the second substrate electrode (4B) from the second active layer; and

**forming** first and second counter electrodes (6A, 6B) onto the first and second active layers, respectively, and thus fill the groove (11A, 11B) with a part of the first counter electrode (6A) to form a conductive portion electrically connecting the first counter electrode (6A) and the second substrate electrode (4B), wherein:

the second active layer is represented by a composition formula: $A_\alpha BX_\chi$, where A denotes at least one cation selected from the group consisting of monovalent cations, B denotes at least one cation selected from the group consisting of bivalent cations, and X denotes at least one ion selected from the group consisting of monovalent halogen ions; and

the second active layer has a first compound layer containing a first compound satisfying $0.95 \leq \alpha$, and $2.95 \leq \chi$, and a second compound layer arranged between the first compound layer and the second substrate electrode (4B), and containing a second compound satisfying $0.2 < \alpha < 0.4$, and $2.2 < \chi < 2.4$.

**Patentansprüche**

1. Photoelektrische Umwandlungsvorrichtung (1), umfassend:

ein Substrat (2);

ein erstes photoelektrisches Umwandlungselement (3A) mit

einer ersten Substratelektrode (4A), die auf dem Substrat (2) angeordnet ist,

einer ersten Aktivschicht, die auf der ersten Substratelektrode (4A) angeordnet ist, und

einer ersten Gegenelektrode (6A), die auf der ersten Aktivschicht angeordnet ist;

ein zweites photoelektrisches Umwandlungselement (3B) mit

einer zweiten Substratelektrode (4B), die auf dem Substrat (2) angeordnet und physikalisch von der ersten Substratelektrode (4A) getrennt ist,

einer zweiten Aktivschicht, die auf der zweiten Substratelektrode (4B) angeordnet ist, und einer zweiten Gegenelektrode (6B), die auf der zweiten Aktivschicht angeordnet ist; und

eine Verbindung (13A, 13B) mit einer Nut (11A, 11B) und einem leitfähigen Abschnitt, wobei die Nut (11A, 11B) die zweite Aktivschicht von einer Oberfläche der zweiten Aktivschicht aus durchdringt, um eine Oberfläche der zweiten Substratelektrode (4B) aus der zweiten Aktivschicht freizulegen, wobei der leitfähige Abschnitt einen Teil der ersten Gegenelektrode (6A) umfasst, der in die Nut (11A, 11B) eingefüllt ist, und wobei die Verbindung (13A, 13B) die erste Gegenelektrode (6A) und die zweite Substratelektrode (4B) über den leitfähigen Abschnitt elektrisch verbindet, wobei:

die zweite Aktivschicht dargestellt ist durch eine Zusammensetzungsformel: $A_\alpha BX_\chi$, worin A mindestens ein Kation bezeichnet, das ausgewählt ist aus der Gruppe bestehend aus einwertigen Kationen, B mindestens ein Kation bezeichnet, das ausgewählt ist aus der Gruppe bestehend aus zweiwertigen Kationen, und X mindestens ein Ion bezeichnet, das ausgewählt ist aus der Gruppe bestehend aus einwertigen Halogenionen; und

die zweite Aktivschicht eine erste und eine zweite Verbindungsschicht aufweist, wobei die erste Verbindungsschicht eine erste Verbindung enthält, die $0.95 \leq \alpha$ und $2.95 \leq \chi$ erfüllt, die zweite Verbindungsschicht zwischen der ersten Verbindungsschicht und der zweiten Substratelektrode (4B) angeordnet ist und die zweite Verbindungsschicht eine zweite Verbindung enthält, die $0.2 < \alpha < 0.4$ und $2.2 < \chi < 2.4$ erfüllt.

2. Vorrichtung gemäß Anspruch 1, wobei
das Substrat (2) mindestens ein organisches Material enthält, das ausgewählt ist aus der Gruppe bestehend aus Polyethylen, Polyethylenterephthalat, Polyethylennaphthalat, Polyimid, Polyamid, Polyamidimid und einem Flüssigkristallpolymer.

3. Vorrichtung gemäß Anspruch 1, wobei
die zweite Substratelektrode (4B) mindestens ein leitfähiges Metalloxid enthält, das ausgewählt ist aus der Gruppe bestehend aus Indiumoxid, Zinkoxid, Zinnoxid, Indiumzinnoxid, fluordotiertem Zinnoxid, galliumdotiertem Zinkoxid, aluminiumdotiertem Zinkoxid, Indiumzinnoxid und Indiumgalliumzinnoxid.

4. Vorrichtung gemäß Anspruch 1, wobei:

   das erste photoelektrische Umwandlungselement (3A) eine erste Zwischenschicht umfasst, die zwischen der ersten Aktivschicht und der ersten Substratelektrode angeordnet ist; und
   das zweite photoelektrische Umwandlungselement (3B) eine zweite Zwischenschicht umfasst, die zwischen der zweiten Aktivschicht und der zweiten Substratelektrode angeordnet ist.

5. Verfahren zur Herstellung einer photoelektrischen Umwandlungsvorrichtung, umfassend:

   Bilden einer ersten und einer zweiten Substratelektrode (4A, 4B) auf einem Substrat (2);
   Bilden einer ersten und einer zweiten Aktivschicht auf jeweils der ersten und der zweiten Substratelektrode (4A, 4B);
   Bilden einer Nut (11A, 11B), die die zweite Aktivschicht von einer Oberfläche der zweiten Aktivschicht aus durchdringt, um eine Oberfläche der zweiten Substratelektrode (4B) aus der zweiten Aktivschicht freizulegen; und
   Bilden einer ersten und einer zweiten Gegenelektrode (6A, 6B) auf jeweils der ersten und der zweiten Aktivschicht, wodurch die Nut (11A, 11B) mit einem Teil der ersten Gegenelektrode (6A) gefüllt wird, um einen leitfähigen Abschnitt zu bilden, der die erste Gegenelektrode (6A) und die zweite Substratelektrode (4B) elektrisch verbindet, wobei:

   die zweite Aktivschicht dargestellt ist durch eine Zusammensetzungsformel: $A_\alpha BX_\chi$, worin A mindestens ein Kation bezeichnet, das ausgewählt ist aus der Gruppe bestehend aus einwertigen Kationen, B mindestens ein Kation bezeichnet, das ausgewählt ist aus der Gruppe bestehend aus zweiwertigen Kationen, und X mindestens ein Ion bezeichnet, das ausgewählt ist aus der Gruppe bestehend aus einwertigen Halogen-nionen; und
   die zweite Aktivschicht eine erste Verbindungsschicht aufweist, die eine erste Verbindung enthält, die $0,95 \leq \alpha$ und $2,95 \leq \chi$ erfüllt, und eine zweite Verbindungsschicht aufweist, die zwischen der ersten Verbindungsschicht und der zweiten Substratelektrode (4B) angeordnet ist und eine zweite Verbindung enthält, die $0,2 < \alpha < 0,4$ und $2,2 < \chi < 2,4$ erfüllt.

**Revendications**

1. Dispositif de conversion photoélectrique (1), comprenant :

   un substrat (2) ;
   un premier élément de conversion photoélectrique (3A) incluant

   une première électrode de substrat (4A) agencée sur le substrat (2),
   une première couche active agencée sur la première électrode de substrat (4A), et
   une première contre-électrode (6A) agencée sur la première couche active ;

   un second élément de conversion photoélectrique (3B) incluant

   une seconde électrode de substrat (4B) agencée sur le substrat (2) et physiquement séparée de la première électrode de substrat (4A),
   une seconde couche active agencée sur la seconde électrode de substrat (4B),
   et une seconde contre-électrode (6B) agencée sur la seconde couche active ; et

une connexion (13A, 13B) incluant une rainure (11A, 11B) et une portion conductrice, la rainure (11A, 11B) pénétrant à travers la seconde couche active depuis une surface de la seconde couche active afin d'exposer une surface de la seconde électrode de substrat (4B) depuis la seconde couche active, la portion conductrice incluant une partie de la première contre-électrode (6A) remplissant la rainure (11A, 11B), et la connexion (13A, 13B) connectant électriquement la première contre-électrode (6A) et la seconde électrode de substrat (4B) via la portion conductrice, dans lequel :

la seconde couche active est représentée par une formule de composition : $A_\alpha BX_\chi$, où A désigne au moins un cation sélectionné dans le groupe consistant en cations monovalents, B désigne au moins un cation sélectionné dans le groupe consistant en cations bivalents et X désigne au moins un ion sélectionné dans le groupe consistant en ions halogénures monovalents ; et
la seconde couche active présente une première et une seconde couche de composé, la première couche de composé contenant un premier composé satisfaisant $0,95 \leq \alpha$, et $2,95 \leq \chi$, la seconde couche de composé étant agencée entre la première couche de composé et la seconde électrode de substrat (4B), et la seconde couche de composé contenant un second composé satisfaisant $0,2 < \alpha < 0,4$, et $2,2 < \chi < 2,4$.

2. Dispositif selon la revendication 1, dans lequel
le substrat (2) contient au moins un matériau organique sélectionné dans le groupe consistant en polyéthylène, polyéthylène téréphtalate, polyéthylène naphtalate, polyimide, polyamide, polyamide-imide et un polymère à cristaux liquides.

3. Dispositif selon la revendication 1, dans lequel
la seconde électrode de substrat (4B) contient au moins un oxyde métallique conducteur sélectionné dans le groupe consistant en oxyde d'indium, oxyde de zinc, oxyde d'étain, oxyde d'indium-étain, oxyde d'étain dopé au fluor, oxyde de zinc dopé au gallium, oxyde de zinc dopé à l'aluminium, oxyde d'indium-zinc et oxyde d'indium-gallium-zinc.

4. Dispositif selon la revendication 1, dans lequel :

le premier élément de conversion photoélectrique (3A) inclut une première couche intermédiaire agencée entre la première couche active et la première électrode de substrat ; et
le second élément de conversion photoélectrique (3B) inclut une seconde couche intermédiaire agencée entre la seconde couche active et la seconde électrode de substrat.

5. Procédé de fabrication d'un dispositif de conversion photoélectrique, comprenant :

la formation de première et seconde électrodes de substrat (4A, 4B) sur un substrat (2) ;
la formation de première et seconde couches actives sur les première et seconde électrodes de substrat (4A, 4B), respectivement ;
la formation d'une rainure (11A, 11B) pénétrant à travers la seconde couche active depuis une surface de la seconde couche active afin d'exposer une surface de la seconde électrode de substrat (4B) depuis la seconde couche active ; et
la formation de première et seconde contre-électrodes (6A, 6B) sur les première et seconde couches actives, respectivement, et ainsi le remplissage de la rainure (11A, 11B) avec une partie de la première contre-électrode (6A) afin de former une portion conductrice connectant électriquement la première contre-électrode (6A) et la seconde électrode de substrat (4B), dans lequel :

la seconde couche active est représentée par une formule de composition : $A_\alpha BX_\chi$, où A désigne au moins un cation sélectionné dans le groupe consistant en cations monovalents, B désigne au moins un cation sélectionné dans le groupe consistant en cations bivalents et X désigne au moins un ion sélectionné dans le groupe consistant en ions halogénures monovalents ; et
la seconde couche active présente une première couche de composé contenant un premier composé satisfaisant $0,95 \leq \alpha$, et $2,95 \leq \chi$ et une seconde couche de composé agencée entre la première couche de composé et la seconde électrode de substrat (4B), et contenant un second composé satisfaisant $0,2 < \alpha < 0,4$, et $2,2 < \chi < 2,4$.

# FIG. 1

FIG. 2A

FIG. 2B

FIG. 2C

# FIG. 3

# FIG. 4

100

102

103a

10

103

101

# FIG. 5

# FIG. 6

# FIG. 7

FIG. 8A

FIG. 8B

P2 ... P2

2 ... 4 ... 5

FIG. 8C

2 ... 4 ... 5 ... 6

FIG. 8D

P3 ... P3

2 ... 4 ... 5 ... 6

EP 3 944 351 B1

FIG. 9A

FIG. 9B

FIG. 9C

# FIG. 10A

# FIG. 10B

# FIG. 10C

# FIG. 11A

# FIG. 11B

# FIG. 12A

511

51X

4A 512 52 4B 510

2

# FIG. 12B

511 11A

51A 51B

4A 512 52A 52B 4B 510

2

# FIG. 12C

6A

511 532A 532B

51A 51B

4A 512 52A 52B 4B 510

2

## FIG. 13A

511  11A

51A        51B

4A  512  4B  510
2  52A 52B

## FIG. 13B

511  11A

51A        51B

4A  512  4B  510
2  52A 52B

## FIG. 13C

511  11A

51A        51B

4A  512  4B  510
2  52A 52B

# FIG. 14

FIG. 15

FIG. 16

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 5715795 B

- JP 6030176 B

**Non-patent literature cited in the description**

- **KUNPENG LI et al.** An efficient, flexible perovskite solar module exceeding 8% prepared with an ultrafast Pbl2 deposition rate. *Scientific Reports*, 11 January 2018, vol. 8, 1-7

- **ENQIANG ZHENG et al.** Pbl2-Based Dipping-Controlled Material Conversion for Compact Layer Free Perovskite Solar Cells. *ACS Applied Materials & Interfaces*, 2015, vol. 7, 18156-18162